Europäisches Patentamt

European Patent Office

Office européen des brevets

(19)

(11) **EP 0 574 070 B1**

(12) **FASCICULE DE BREVET EUROPEEN**

(45) Date de publication et mention
de la délivrance du brevet:
**10.10.2001 Bulletin 2001/41**

(51) Int Cl.⁷: **G06F 13/40**, H03K 17/08,
H03K 19/003

(21) Numéro de dépôt: **93201567.0**

(22) Date de dépôt: **02.06.1993**

(54) **Circuit interface de liaison entre microprocesseurs**

Schnittstellenanordnung zur Verbindung von Mikroprozessoren

Interface circuit for linking microprocessors

(84) Etats contractants désignés:
**DE FR GB**

(30) Priorité: **10.06.1992 FR 9206985**

(43) Date de publication de la demande:
**15.12.1993 Bulletin 1993/50**

(73) Titulaire: **Koninklijke Philips Electronics N.V.
5621 BA Eindhoven (NL)**

(72) Inventeur: **Perraud, Jean-Claude
156,Boulevard Haussmann, F-75008 Paris (FR)**

(74) Mandataire: **Charpail, François et al
Société Civile S.P.I.D.
156, Boulevard Haussmann
75008 Paris (FR)**

(56) Documents cités:
**EP-A- 0 258 873        EP-A- 0 281 684
WO-A-83/04351        WO-A-85/03818**

Printed by Jouve, 75001 PARIS (FR)

**Description**

La présente invention concerne un circuit interface de liaison entre microprocesseurs, destiné à assurer que le courant de cette liaison ne dépasse pas une valeur limite par l'interposition, dans cette liaison, du trajet émetteur-collecteur d'un premier transistor.

Dans un système de lecture d'une carte à mémoire notamment, un certain nombre de liaisons sont établies entre le microprocesseur situé dans la carte et le microprocesseur du lecteur de carte. Parmi ces liaisons, celles du type dit "entrée/sortie" sont chargées d'échanger des données entre les deux microprocesseurs. Lorsque le système fonctionne normalement, l'un des deux microprocesseurs envoie à basse impédance des signaux que l'autre microprocesseur reçoit à relativement haute impédance et les impulsions de courant correspondant à ces informations restent faibles et ne dépassent pas en général une valeur de 2mA.

Il ne faut cependant pas écarter l'hypothèse d'un défaut de fonctionnement du système conduisant à ce que les deux microprocesseurs tentent d'imposer à basse impédance, et simultanément, des états logiques opposés. Il se produit alors un courant excessif dans la liaison au point que l'un ou l'autre microprocesseur, est détruit par excès de courant. Le même résultat se produit dans le cas d'un court-circuit accidentel entre la liaison et l'une des bornes d'alimentation. En particulier dans le cas d'un système de lecture de carte à microcircuit, le microprocesseur situé dans la carte ne peut tolérer un courant de sortie dépassant une dizaine de mA. Une situation particulièrement fâcheuse est celle qui peut se produire lorsqu'un lecteur de carte à microcircuit est défectueux et que tous les usagers présentent leur carte dans ce lecteur vont successivement détruire leur propre carte à la suite de ce défaut.

L'invention concerne donc un circuit interface destiné à limiter le courant circulant dans la liaison entre deux microprocesseurs de manière à éviter la destruction de l'un ou l'autre des microprocesseurs, et qui fournisse de préférence un signal avertissant du mauvais état de fonctionnement du système et permettant d'interrompre toute autre opération échangée sur la liaison.

D'une manière générale, il est connu que le trajet émetteur/collecteur d'un transistor interposé en ballast dans une liaison, est à-même d'interposer une chute de tension dans cette liaison lorsque le courant circulant dans la liaison dépasse une valeur limite fixée, sous la commande d'un courant de base prédéterminé.

Un montage dans lequel un transistor est interposé en ballast pour l'alimentation d'une charge est connu notamment du document EP-A-0 339 736. Toutefois, ce document fournit une solution à un problème technique très différent de celui envisagé dans le cadre de la présente invention.

Ainsi l'invention à pour but de proposer un circuit interface de liaison entre microprocesseurs offrant une protection efficace en cas de surcharge de courant dans la liaison.

Un tel circuit interface selon l'invention est caractérisé en ce qu'il comporte un deuxième transistor de même polarité et de géométrie k fois plus petite que celle du premier transistor, dont l'émetteur et la base sont respectivement connectés à l'émetteur et à la base du premier transistor, et en ce qu'il comporte un générateur de courant de base qui reçoit sur une entrée le courant collecteur Iy du deuxième transistor et qui délivre sur une sortie un courant Iz alimentant ensemble les bases des premier et deuxième transistors, courant Iz qui est égal à un courant de référence auquel est retranché un courant déduit du courant Iy selon une loi telle qu'au delà de la valeur limite du courant dans la liaison, le premier transistor quitte le régime de saturation où il est placé normalement et interpose alors une chute de tension dans la liaison.

Lorsque le courant circulant dans la liaison est normal le premier transistor est en régime de forte saturation et interpose dans cette liaison une chute de tension très faible et qui est négligeable en pratique. Plutôt que d'alimenter ensemble les bases des premier et deuxième transistors avec un courant fixe, l'invention prévoit au contraire que le courant Iz, délivré par le générateur de courant de base, décroît lorsque le courant mesuré par le deuxième transistor croît, de sorte que le changement de régime du premier transistor est plus accentué et plus précis.

Dans un premier mode de mise en oeuvre de l'invention, le circuit d'interface est caractérisé en ce que le générateur de courant de base comprend une source de courant servant à générer le courant de référence, un premier miroir de courant dont une sortie constitue la sortie du générateur fournissant le courant Iz, et un deuxième miroir de courant dont une entrée constitue l'entrée du générateur, recevant le courant Iy, et dont une sortie fournit un courant qui est retranché au courant de référence, cette différence de courant étant appliquée à l'entrée du premier miroir de courant.

Dans sa constitution, le générateur de courant de base est commandé par un courant et délivre une différence de courant à l'aide de miroirs de courant de sorte qu'il peut être rendu pratiquement insensible à la température. Selon ce premier mode de mise en oeuvre on peut, pour simplifier, utiliser des premier et deuxième miroirs de courant à rapports de courant entrée/sortie égaux à 1. Le circuit interface fonctionne en régime stable, maintenant un courant limite dans la liaison par interposition d'une chute de tension dans le premier transistor, placé hors saturation, en cas d'anomalie.

Selon une variante de ce mode de mise en oeuvre, les premier et deuxième miroirs de courant peuvent être dotés respectivement de fateurs multiplicatifs m et n de leur courant de sortie par rapport à leur courant d'entrée. Selon cette variante, la valeur limite du courant de liaison peut être rendue moins dépendante de la valeur du gain en courant des premier et deuxième transistors.

Un deuxième mode de mise en oeuvre du circuit interface selon l'invention est caractérisé en ce que le premier miroir de courant possède une sortie supplémentaire qui débite un courant affecté d'un facteur multiplicatif p par rapport à son courant d'entrée, et en ce que cette sortie supplémentaire est connectée à l'entrée du deuxième miroir de courant de sorte que ce deuxième miroir de courant ne débite pas tant que le courant de collecteur Iy du deuxième transistor reste inférieur au courant $I_0$ fourni à la sortie supplémentaire du premier miroir de courant. Selon ce mode de mise en oeuvre, le courant Iz d'alimentation des bases des premier et deuxième transistors reste fixe et de valeur égale à $m.I_0$ tant que le courant dans la liaison ne dépasse pas un seuil de courant qui peut être déterminé. Au delà de ce seuil de courant, le courant d'alimentation Iz des bases des premier et deuxième transistors décroît. Lorsque les coefficients multiplicatifs m, n et p sont choisis judicieusement, cette décroissance est du type à réaction positive et s'opère de manière rapide pour placer le premier transistor dans un état de faible conduction. Le courant dans la liaison se stabilise alors à une valeur qui n'est qu'une fraction du seuil de courant qui avait été précédemment franchi. Ce mode de mise en oeuvre de l'invention offre donc une protection supplémentaire en cas de surcharge de courant dans la liaison.

Dans la plupart des cas, la liaison entre microprocesseurs véhicule des signaux réversibles c'est-à-dire provenant de l'un ou de l'autre de ces microprocesseurs. Le circuit interface selon l'invention s'applique également à ce cas dans un mode de mise en oeuvre dans lequel les éléments constitutifs sont, pour l'essentiel, doublés et qui est caractérisé en ce qu'au premier transistor est associé un troisième transistor, de même polarité, dont le collecteur est connecté à l'émetteur du premier transistor et dont l'émetteur est connecté au collecteur du premier transistor, en ce qu'un quatrième transistor, de même polarité et de surface k fois plus petite que celle du troisième transistor, est également associé au troisième transistor, les bases et les émetteurs des troisième et quatrième transistors étant respectivement connecté entre eux, et en ce que le générateur de courant de base reçoit sur une entrée additionnelle le courant collecteur I'y du quatrième transistor et délivre sur une sortie additionnelle un courant Iz' alimentant ensemble les bases des troisième et quatrième transistors, dont la loi de variation par rapport à Iy' et $I_0$ est identique à la loi de variation du courant Iz par rapport au courant Iy.

Les modes particuliers de mise en oeuvre de l'invention pour une liaison bidirectionnelle se déduisent essentiellement des modes déjà indiqués concernant une liaison unidirectionnelle.

D'autres particularités, détails et avantages de l'invention seront mis en évidence par la description qui va suivre en regard des dessins annexés qui sont relatifs à des exemples donnés à titre non limitatif, dans lesquels :

la figure 1 montre le schéma électrique d'un premier exemple de réalisation du circuit interface selon l'invention et la figure 2 un diagramme relatif à son fonctionnement,
la figure 3 donne le schéma d'un deuxième exemple de réalisation de l'invention et la figure 4, un diagramme relatif à son fonctionnement,
la figure 5 montre le schéma d'un exemple de réalisation d'un circuit générateur d'un signal d'alarme, qui peut être associé au circuit de la figure 1, et la figure 6, un diagramme permettant de préciser son fonctionnement.

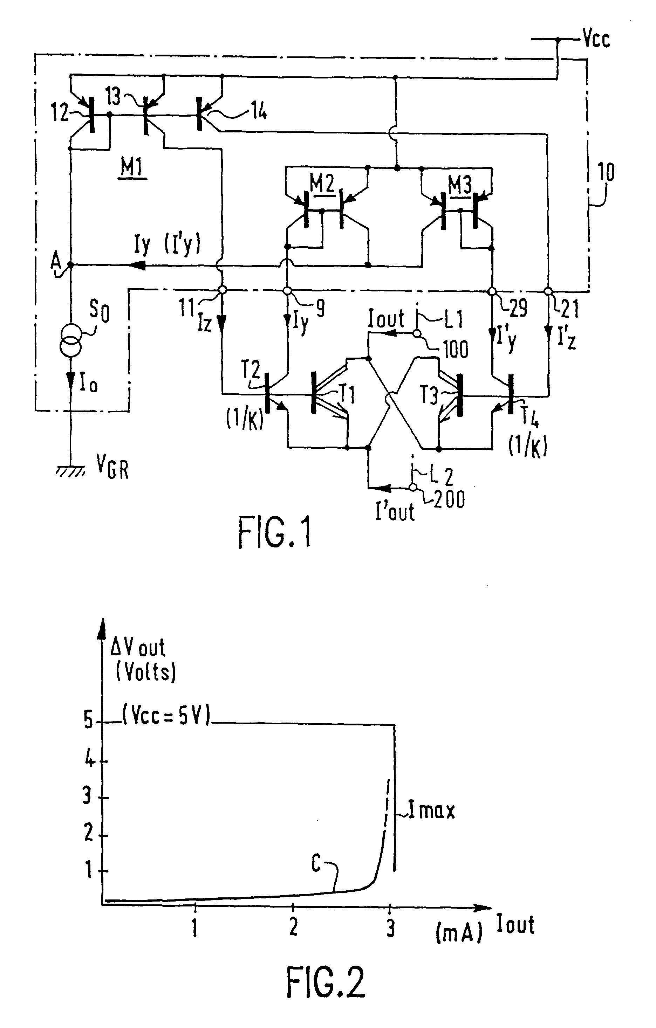

Sur la figure 1, une liaison L1-L2 est interrompue entre les bornes 100 et 200 et le trajet émetteur/collecteur d'un premier transistor $T_1$ est interposé entre ces bornes. On supposera tout d'abord que le courant de liaison Iout circule de la borne 100 vers la borne 200. Un deuxième transistor $T_2$ de même polarité que le premier transistor $T_1$ et de géométrie k fois plus petite que celle du transistor $T_1$, a son émetteur et sa base respectivement connecté à l'émetteur et à la base du transistor $T_1$. Le courant collecteur du deuxième transistor $T_2$ est noté Iy et ce collecteur est connecté à une borne d'entrée 9 d'un générateur de courant de base 10 lequel délivre sur une borne de sortie 11, un courant Iz alimentant ensemble les bases des premier et deuxième transistor $T_1$ et $T_2$. On a choisi une valeur de courant de ligne Imax au delà de laquelle le fonctionnement du système est considéré comme anormal et le circuit d'interface doit interposer une impédance convenable pour éviter la destruction des microprocesseurs. En dessous du courant de liaison Imax on considère au contraire que l'état du système est normal et le premier transistor $T_1$ est prévu pour fonctionner en régime de saturation, le courant Iz de la sortie 11 du générateur de courant de base 10 étant suffisamment élevé. Selon l'exemple représenté à la figure 1, le courant Iz est égal à un courant fixe $I_0$ délivré par une source de courant $S_0$ auquel est retranché une valeur égale au courant Iy délivré par le collecteur du transistor $T_2$. Pour réaliser cette fonction, la source de courant $S_0$ est disposée entre une tension de référence $V_{GR}$ et une source d'alimentation $V_{cc}$ la liaison entre la source de courant $S_0$ et la tension d'alimentation $V_{cc}$ comportant un premier miroir de courant M1, référencé à la tension d'alimentation $V_{cc}$, formé du transistor d'entrée 12 et du transistor de sortie 13, le transistor 12 étant connecté en diode. Le générateur de courant de base 10 comporte également un deuxième miroir de courant M2 également référencé à la tension d'alimentation $V_{cc}$, commandé en entrée par le courant Iy de la borne 9 et délivrant en sortie sensiblement le même courant Iy vers un noeud A, de connexion entre l'entrée du premier miroir de courant M1 et la source de courant $S_0$. Ainsi donc, le premier miroir de courant M1 est commandé par un courant de valeur égale à $I_0$ - Iy et délivre sur la borne de sortie 11 un courant sensiblement identique Iz = $I_0$ - Iy.

La figure 2 représente l'allure de la variation de la chute de tension entre les bornes 100 et 200 en fonction du courant de liaison Iout. Lorsque le courant de liaison Iout est faible, le premier transistor $T_1$ est en saturation tandis que le deuxième transistor $T_2$ n'est pas en régime de saturation et délivre par conséquent un courant Iy qui est plus élevé (de par exemple supérieur à 2 fois) que la valeur de courant Iout/k, le paramètre k étant égal au rapport de surface entre le transistor $T_1$ et le transistor $T_2$. Lorsque le courant de liaison Iout augmente le courant Iz diminue de sorte que le régime de saturation du premier transistor $T_1$ diminue progressivement et corrélativement le rapport entre le courant Iy et le courant Iout se rapproche progressivement de la valeur du rapport 1/k. Ce rapport est pratiquement atteint lorsque le premier transistor $T_1$ quitte le régime de saturation. Le calcul suivant permet d'évaluer une valeur approchée du courant de liaison Imax qui ne peut être dépassé dans la liaison, en prenant en compte uniquement les éléments du circuit de la figure 1 qui ont été cités jusqu'ici.

$$Iy = Imax/k$$

$$I_z = I_0 - Imax/k \qquad (1)$$

En supposant que le gain en courant des transistors $T_1$ et $T_2$ est identique, et égal à $\beta$, le courant $I_z$ correspond à l'alimentation des bases de $T_1$ et $T_2$. donc :

$$I_z = Imax/\beta + Imax/k.\beta \qquad (2)$$

En combinant les relations (1) et (2), il vient :

$$Imax = k.I_0/(1 + k/\beta + 1/\beta) \qquad (3)$$

A titre d'exemple, en prenant $I_0 = 150\mu A$ et k = 24
Imax = 2,4 mA pour $\beta$ = 50
    = 2,88 mA pour $\beta$ = 100
et   = 3,2 mA pour $\beta$ = 200

La courbe C de la figure 2 montre un exemple pratique de la variation de $\Delta$Vout (chute de tension entre les bornes 100 et 200), en fonction du courant de liaison Iout dans le cas où par construction le deuxième transistor $T_2$ est 24 fois plus petit que le transistor $T_1$. Une protection convenable est donc assurée s'il est prévu que le courant nominal dans la liaison ne dépasse pas 2 mA.

La description donnée jusqu'ici considère un circuit interface de type unidirectionnel c'est-à-dire pour lequel Iout circule dans le sens de la borne 100 vers la borne 200. En pratique, la liaison qui est à protéger est le plus souvent de type bidirectionnel. La figure 1 indique quels sont les éléments à ajouter pour obtenir un tel circuit interface bidirectionnel. Au premier transistor $T_1$ est associé un troisième transistor $T_3$ de même polarité que le transistor $T_1$, dont le collecteur est connecté à l'émetteur du transistor $T_1$ et dont l'émetteur est connecté au collecteur du transistor $T_1$ (connexion des trajets émetteur/collecteur inversée). De manière similaire, un quatrième transistor $T_4$ de même polarité est associé au troisième transistor $T_3$ les bases et les émetteurs des troisième et quatrième transistors $T_3$, $T_4$ sont respectivement connectés entre eux et le transistor $T_4$ est de géométrie k fois plus petite que celle du transistor $T_3$. Pour assurer la symétrie du fonctionnement, les transistors $T_1$ et $T_3$ sont de géométrie et structure identiques. Le générateur de courant de base 10 reçoit sur une entrée additionnelle 29, le courant collecteur Iy' du quatrième transistor $T_4$, et délivre sur une borne de sortie additionnelle 21, un courant d'alimentation de base I'z alimentant ensemble les bases des transistors $T_3$ et $T_4$. Pour assurer la même loi de variations de I'z par rapport à I'y et $I_0$, le premier miroir de courant M1 comporte un transistor additionnel 14 délivrant sur son collecteur un courant I'z qui est égal à $I_0$ - I'y par le fait qu'un troisième miroir de courant M3 reçoit en entrée le courant I'y et délivre sur le noeud A une copie de ce courant. La partie additionnelle du circuit qui vient d'être décrite, se comporte la même manière que sa partie symétrique décrite précédemment de sorte qu'elle réalise la même fonction caractéristique pour un courant de liaison I'out circulant dans le sens de la borne 200 vers la borne 100.

Les explications données précédemment à propos de la moitié du circuit de la figure 1 pour un circuit unidirectionnel restent valables puisque dans le cas du circuit bidirectionnel, l'un des couples de transistors $T_1$, $T_2$ ou $T_3$, $T_4$ est placé en situation de fonctionnement inversé du fait du courant passant dans le sens émetteur vers collecteur. Le courant transféré dans le trajet émetteur-collecteur de ces transistors reste faible de sorte que son incluence peut être négligée par rapport au fonctionnement du couple de transistors fonctionnant en direct.

Il est a remarquer que les miroirs de courant M1, M2 et M3 peuvent être choisis avec un rapport de courant de sortie sur courant d'entrée différent de 1.

On définit alors un facteur multiplicatif m pour le miroir de courant M1 (identique pour ses deux sorties) et un facteur multiplicatif n pour le miroir de courant M2 (et pour le miroir de courant M3). Un calcul analogue à celui donné à propos de la figure 1 montre que la relation (3), qui permet d'évaluer le courant limite Imax, devient alors :

$$Imax = k.I_0 \, / \, (n + \frac{k+1}{\beta.m}) \qquad (4)$$

On observe que l'influence du gain en courant $\beta$ sur la valeur de Imax peut être minimisée en choisissant m et/ou n plus grand que l'unité.

A titre d'exemple, en prenant $I_0 = 250\mu A$, k =

28 et m = n = 2.

Imax = 3,05 mA pour $\beta$ = 50

$\quad\quad$ = 3,26 mA pour $\beta$ = 100

$\quad\quad$ = 3,38 mA pour $\beta$ = 200

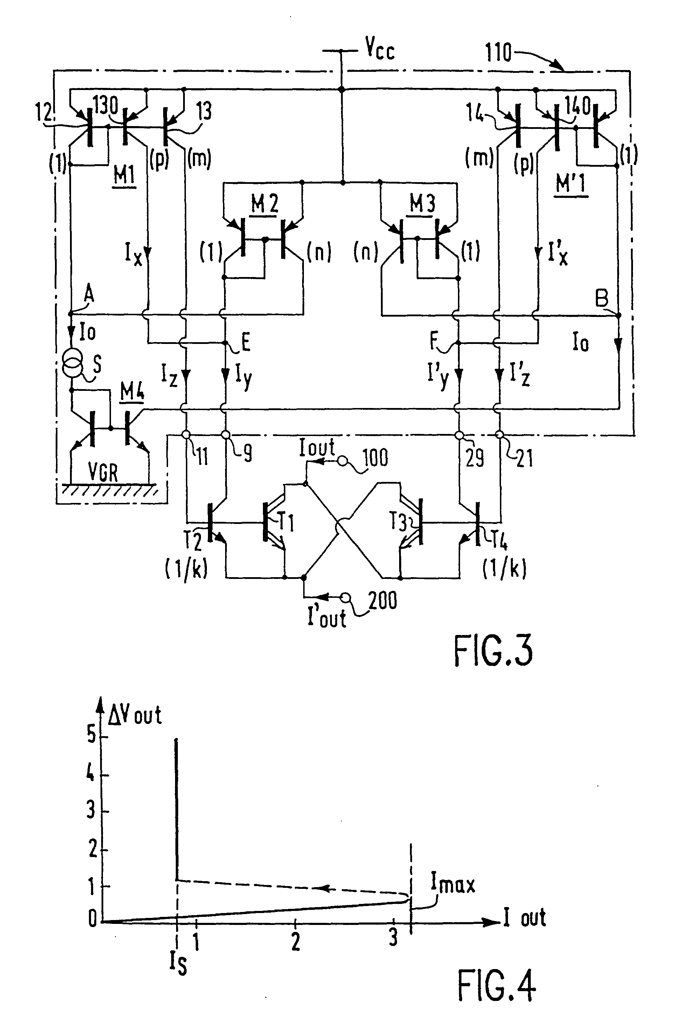

La figure 3 indique le schéma d'un deuxième exemple de réalisation d'un circuit interface selon l'invention. Sur cette figure les éléments ayant même fonction que sur la figure 1 sont affectés des mêmes signes de référence. Dans le présent exemple, la disposition des transistors $T_1$, $T_2$, $T_3$, $T_4$ entre les bornes 100 et 200 de la liaison, entre les microprocesseurs, est identique à celle de la figure 1. Le générateur de courant de base 110 présente, lui, des différences et notamment à propos de la loi de variation entre le courant Iz, (I'z) pour l'alimentation des bases des premier et deuxième transistors $T_1$, $T_2$ (troisième, quatrième transistors $T_3$, $T_4$) par rapport au courant Iy, (I'y) de collecteur des transistors $T_2$, ($T_4$). Dans le générateur de courant de base 110, une source de courant S délivre un courant $I_0$ à l'entrée d'un premier miroir de courant M1, le même courant $I_0$ étant recopié par un miroir de courant M4 référencé à la tension de référence $V_{GR}$ et appliqué à l'entrée de commande d'un autre miroir de courant M'1, dont la fonction vis-à-vis des transistors $T_3$ et $T_4$ est très semblable à celle du premier miroir M1 vis-à-vis des transistors $T_1$ et $T_2$. Le premier miroir de courant M1 comporte outre le transistor 13 un transistor additionnel 130 dont le collecteur constitue une sortie supplémentaire de ce miroir de courant. Les géométries des transistors 13 et 130 par rapport au transistor de commande 12 sont choisies de telle sorte que les courants de sortie sont affectés d'un facteur multiplicatif m, respectivement p, par rapport au courant d'entrée de commande du premier miroir. Une disposition similaire est appliquée à l'autre miroir de courant M'1 dans laquelle un transistor supplémentaire 140 constitue sur son collecteur une sortie supplémentaire de facteur multiplicatif p tandis que le transistor de sortie 14 constitue sur son collecteur une sortie à facteur multiplicatif m par rapport au courant d'entrée. Le collecteur du transistor 130 est relié à un noeud E de liaison entre la borne 9 et l'entrée du deuxième miroir de courant M2 tandis que le collecteur du transistor 140 est relié de manière similaire à un noeud F de liaison entre la borne 29 et l'entrée du troisième miroir de courant M3. Le deuxième miroir de courant M2 reçoit en entrée un courant égal à la différence (Iy - Ix), lorsque cette différence est positive, et délivre en sortie un courant affecté d'un facteur multiplicatif n, appliqué sur le noeud A de liaison entre la source de courant S et l'entrée du premier miroir de courant M1. De manière similaire, le troisième miroir de courant M3 reçoit en entrée un courant égal à la différence (I'y - I'x), lorsqu'elle est positive, et délivre en sortie un courant affecté du facteur multiplicatif n, appliqué sur un noeud B, homologue du noeud A, mais vis-à-vis de l'entrée de l'autre miroir de courant M'1.

Le fonctionnement du circuit est expliqué en liaison avec la figure 4 qui montre l'allure de la chute de tension $\Delta$Vout en fonction du courant Iout dans la liaison, considéré comme circulant dans le sens de la borne 100 vers la borne 200. Ce fonctionnement se base sur le fait que tant que le courant Iout, de la liaison, reste suffisamment faible, (c'est-à-dire dans la limite du fonctionnement normal), le courant Iy de collecteur du transistor $T_2$ est inférieur au courant $I_x = pI_0$ débité par le collecteur du transistor 130, et le deuxième miroir de courant M2 ne débite pas.

Lorsque Iout croît, la différence de courant $pI_0$ - Iy décroît. Une valeur limite Imax du courant de liaison Iout est atteinte lorsque la différence ($pI_0$ - Iy) change de signe, et que le deuxième miroir de courant M2 commence à débiter. Le courant de sortie de ce miroir M2, est appliqué au noeud A, pour être soustrait du courant $I_0$, et le premier miroir de courant M1 reçoit maintenant en entrée un courant qui décroît par rapport à la situation précédente. Par un choix approprié des facteurs multiplicatifs m, n et p, on va montrer que le circuit de la figure 3 est susceptible d'entrer en réaction et de se stabiliser à une valeur $I_s$ du courant de liaison Iout qui n'est qu'une fraction du courant limité Imax.

Lorsque Imax est atteint, la différence ($pI_0$ - Iy) est négative et très petite ; une valeur approchée de Imax est donc :

$$\text{Imax} \simeq k.p.I_0$$

ce qui suppose que les transistors $T_1$ et $T_2$ ont le même gain en courant. En pratique, la valeur de Imax ainsi déterminée se révèle une valeur approchée par excès car il faudrait utiliser une valeur de k inférieure au rapport géométrique des transistors $T_1$ et $T_2$ pour tenir compte de l'état de saturation du transistor $T_1$.

Le courant de stabilisation, $I_s$ va être maintenant évalué.

Appelons Ix le courant débité par le transistor 130

$$Iz = (m/p).Ix$$

or

$$Iy = \beta.Iz / (k+1)$$

ce qui donne :

$$Iy = \frac{m}{p}\ \beta\ \frac{Ix}{(k+1)} \quad\quad (5)$$

D'autre part, le courant Ix peut être évalué en tenant compte du deuxième miroir de courant M2 :

$$Ix/_p = I_o - n (Iy - Ix) \qquad (6)$$

En combinant les relations (5) et (6) et en utilisant Is = k.Iy, puisque les transistors $T_1$ et $T_2$ sont hors saturation, on aboutit à :

$$IS = k.p.I_o/[p.n - \frac{p}{m.\beta} \cdot (K+1) (p.n - 1)] \qquad (7)$$

Comme $k.p.I_0$ = Imax, on observe que Is est susceptible d'être inférieur à Imax pour certaines valeurs des paramètres k, m, n et p. Par ailleurs, l'influence du gain en courant β est moins marquée lorsque m est choisi plus grand que p.

Lorsque tous les facteurs m, n et p sont pris égaux à 1, on obtient que Is = Imax.

Le tableau qui suit fournit quelques exemples numériques obtenus par la relation (7), avec $I_0$ = 50 μA, k = 24 et donc
Imax = 3,6 mA
pour m = 2 , n = 3 et p = 3

$I_s$     = 1,20 avec β = 50
        = 0,60 avec β = 100
        = 0,48 avec β = 200

pour m = 3, n = 3 et p = 1

$I_s$     = 1,35 avec β = 50
        = 1,27 avec β = 100
        = 1,23 avec β = 200

L'évaluation qui précède est approximative et a été déterminée en tenant compte seulement d'une moitié du circuit de la figure 3. Comme on l'a déjà remarqué à propos du schéma de la figure 1, l'adjonction de la moitié complémentaire du circuit pour le rendre bidirectionnel n'a qu'une influence mineure sur l'allure des phénomènes mis en jeu de sorte que les résultats obtenus avec le circuit complet de la figure 3 restent voisins.

La présence des miroirs de courant M1 et M'1 fournit, dans l'exemple décrit, une commande indépendante des transistors $T_1$ et $T_3$ en fonction du sens du courant de liaison Iout.

Bien entendu, des modes de réalisation de générateur de courant de base, autres que ceux décrits dans les exemples précédents, peuvent être imaginés par le spécialiste. Un résultat similaire sera obtenu lorsque le courant Iz fourni par le générateur de courant de base est une fonction régressive du courant Iy appliqué à l'entrée de ce générateur, à partir d'un courant de référence fixé $I_0$. Pour éviter une consommation de courant inutile dans le circuit interface selon l'invention, il est avantageux de choisir un rapport de surface des transistors $T_1 / T_2$, et $T_3 / T_4$, c'est-à-dire un facteur k, qui soit relativement élevé, de l'ordre de 20 à 30. Ainsi, excepté les transistors $T_1$ et $T_3$, tous les autres transistors du circuit peuvent être choisis de la dimension minimale correspondant à la technologie utilisée.

Bien entendu, si les exemples décrits font appel à des transistors $T_1$, $T_2$, $T_3$ et $T_4$ de type npn, l'invention s'applique également au cas où tous les transistors sont de type opposé à celui décrit, la tension d'alimentation du circuit étant inversée.

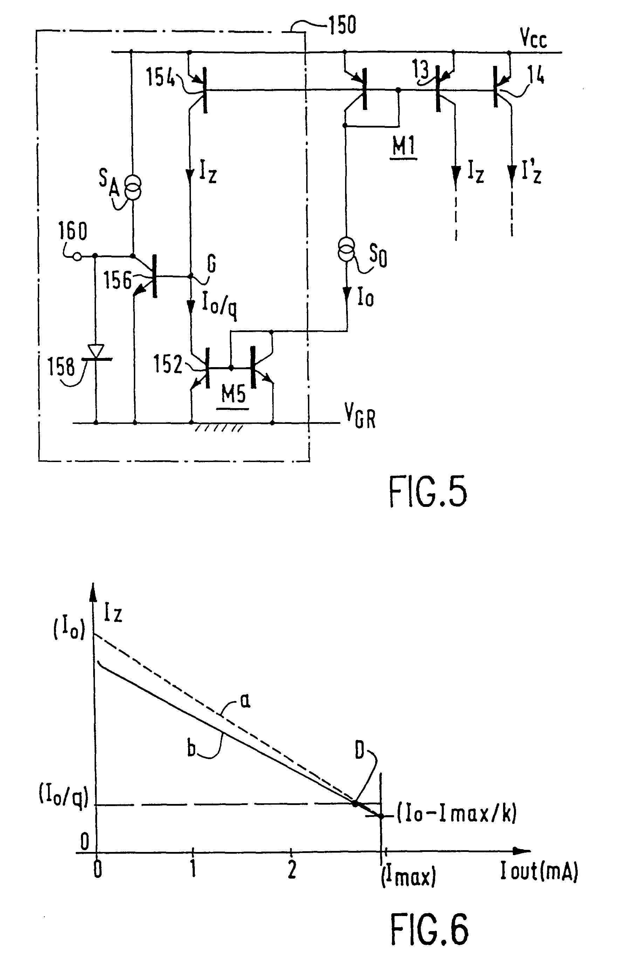

Le figure 5 montre un exemple de réalisation d'un générateur de signal d'alarme 150 détectant l'état de saturation des transistors $T_1$ et $T_3$ du circuit de la figure 1. Sur la figure 5, uniquement le premier miroir de courant M1 et la source de courant de référence So ont été représentés. La source de courant So est connectée maintenant à l'entrée d'un miroir de courant M5, référencé à la tension de référence $V_{GR}$. Ce miroir de courant M5 a sa sortie constituée d'un transistor 152 dimensionné de telle sorte qu'il reproduit une fraction 1/q du courant d'entrée $I_0$, le facteur q étant > 1 et déterminé d'une manière qui sera expliquée par la suite. Le premier miroir de courant M1 comporte une sortie annexe constituée par le collecteur d'un transistor 154 qui débite une copie du courant Iz (ou I'z, selon le cas) sur un noeud G auquel le collecteur du transistor 152 est également connecté. Le noeud G est donc soumis à la différence des courants Iz et $I_0$/q. Il est connecté à la base d'un transistor 156, dont l'émetteur est connecté à la tension $V_{GR}$ et dont le collecteur est alimenté, à partir de la tension $V_{CC}$, par une source de courant $S_A$, et relié par ailleurs à la tension $V_{GR}$ via une jonction 158 en direct. Au collecteur du transistor 156 est enfin relié une borne de sortie 160 pour le signal d'alarme qui est significatif d'un courant excessif dans la liaison, lorsqu'il est à l'état haut.

Le fonctionnement du générateur de signal d'alarme 150 est maintenant expliqué en liaison avec le diagramme de la figure 6 qui montre un exemple de variation du courant Iz (alimentant les bases des transistors $T_1$ et $T_2$) en fonction du courant Iout dans la liaison. Pour un courant Iout nul, le courant Iz serait égal à $I_0$ si le transistor $T_1$ n'était pas en saturation, alors que pour un courant de liaison égal à Imax, Iz devient sensiblement égal à $I_0$ - Imax/k puisqu'alors le transistor $T_1$ n'est plus saturé. La droite référencée $\underline{a}$ représente la variation linéaire correspondant à l'expression $I_0$ - Iout/k.

Cependant, la courbe $\underline{b}$ correspondant à une évaluation très détaillée du courant Iz s'écarte assez peu de la droite $\underline{a}$ du fait de la saturation plus ou moins prononcée du transistor $T_1$, et elle s'en écarte d'autant moins que l'on se rapproche du courant Imax. On se fixe une valeur de $I_0$/q (et donc un facteur q), de telle sorte que la valeur $I_0$/q intercepte la courbe b pour un courant Iout un peu inférieur à Imax mais toutefois supérieur au courant de liaison qui correspond à une utilisation normale. Le point D sur la courbe $\underline{b}$ correspond au changement de signe de la différence de courant Iz - $I_0$/q. Il s'en suit que pour un courant de liaison normal, le transistor 156 est passant et procure un état logique 0 sur la borne de sortie 160 tandis que pour un courant de liaison anormalement élevé, le transistor 156 est bloqué. Un signal d'état logique 1 sur la borne de sortie 160 est alors fourni qui peut être utilisé de manière convenable par l'un des microprocesseurs pour interrompre le processus d'échange de données, par exemple en faisant appel à une interruption non masquable de ce microprocesseur.

En ce qui concerne le circuit interface décrit à la figure 3, la génération d'un signal d'alarme basée sur le même principe que celui représenté à la figure 5 peut être aisément mise en oeuvre. Il est à remarquer cependant que, par l'utilisation des deux miroirs de courant M1 et M'1, il est utile de prévoir deux générateurs de signaux du type du générateur 150 de la figure 5, dont les sorties telles que 160 sont appliquées à deux entrées d'une porte OU, laquelle délivre alors sur sa sortie un signal d'alarme indépendant du sens du courant Iout dans la liaison.

Par ailleurs, lorsqu'on prévoit de fonctionner dans des conditions de réaction positive du circuit de la figure 3, procurant un courant de stabilisation Is inférieur au courant Imax, le courant Iz ne présente que deux valeurs possibles bien distinctes l'une de l'autre. Il est aisé de choisir le courant fixe, proportionnel à $I_0$, qui soit intermédiaire entre ces deux valeurs et déclenche un signal d'alarme dès que le courant de liaison s'est fixé à sa valeur de sécurité Is. Il est aussi possible de produire un signal d'alarme, de façon très simple, dans les conditions de réaction positive du circuit de la figure 3, en déduisant ce signal des miroirs de courant M2 et M3 dont l'un ou l'autre ne débite qu'en présence d'une anomalie, et indique que le courant de liaison a dépassé la valeur nominale prévue.

## Revendications

1. Circuit interface de liaison entre microprocesseurs, destiné à assurer que le courant de cette liaison ne dépasse pas une valeur limite par l'interposition, dans cette liaison (L1-L2), du trajet émetteur-collecteur d'un premier transistor ($T_1$), **caractérisé en ce qu'**il comporte un deuxième transistor ($T_2$) de même polarité et de géométrie k fois plus petite que celle du premier transistor, dont l'émetteur et la base sont respectivement connectés à l'émetteur et à la base du premier transistor, et **en ce qu'**il comporte un générateur de courant de base (10) qui reçoit sur une entrée le courant collecteur Iy du deuxième transistor et qui délivre sur une sortie un courant Iz alimentant ensemble les bases des premier et deuxième transistors, courant Iz qui est égal à un courant de référence auquel est retranché un courant déduit du courant Iy selon une loi telle qu'au delà de la valeur limite du courant dans la liaison, le premier transistor quitte le régime de saturation où il est placé normalement et interpose alors une chute de tension dans la liaison.

2. Circuit interface selon la revendication 1, **caractérisé en ce que** le générateur de courant de base comprend une source de courant (So) servant à générer le courant de référence ($I_0$), un premier miroir de courant (M1) dont une sortie constitue la sortie du générateur fournissant le courant Iz, et un deuxième miroir de courant (M2) dont une entrée constitue l'entrée du générateur recevant le courant Iy, et dont une sortie fournit un courant qui est retranché au courant de référence, cette différence de courant étant appliquée à l'entrée du premier miroir de courant.

3. Circuit interface selon la revendication 2, **caractérisé en ce que** les premier et deuxième miroirs de courant sont dotés respectivement de facteurs multiplicatif m et n de leur courant de sortie par rapport à leur courant d'entrée.

4. Circuit interface selon la revendication 3, **caractérisé en ce que** le premier miroir de courant possède une sortie supplémentaire, qui débite un courant $I_x$ affecté d'un facteur multiplicatif p par rapport à son courant d'entrée, et **en ce que** cette sortie supplémentaire est connectée à l'entrée du deuxième miroir de courant de sorte que ce deuxième miroir de courant ne débite pas tant que le courant collecteur Iy du deuxième transistor reste inférieur au courant de valeur $I_x$ fourni à la sortie supplémentaire du premier miroir de courant.

5. Circuit interface selon la revendication 4, **caractérisé en ce que** les facteurs multiplicatifs m, n et p sont choisis de telle sorte que le circuit se stabilise, par réaction positive, à une valeur $I_s$ du courant de liaison, qui est inférieure à une limite Imax du courant de liaison, lorsqu'elle a été atteinte.

6. Circuit interface selon la revendication 1, **caractérisé en ce qu'**au premier transistor est associé un troisième transistor ($T_3$), de même polarité, dont le collecteur est connecté à l'émetteur du premier transistor, et dont l'émetteur est connecté au collecteur du premier transistor, **en ce qu'**un quatrième transistor ($T_4$), de même polarité et de géométrie k fois plus petite que celle du troisième transistor, est également associé au troisième transistor, les bases et les émetteurs des troisième et quatrième transistors étant respectivement connectés entre eux, et **en ce que** le générateur de courant de base reçoit sur une entrée additionnelle un courant collecteur Iy' du quatrième transistor et délivre sur une sortie additionnelle un courant Iz' alimentant ensemble les bases des troisième et quatrième transistors, dont la loi de variation par rapport à I'y et $I_0$

est identique à la loi de variation du courant Iz par rapport aux courants Iy et $I_0$ et est obtenue par des moyens semblables, comprenant un troisième miroir de courant (M3) dont l'entrée constitue ladite entrée additionnelle du générateur de courant de base.

**7.** Circuit interface selon les revendications 3 et 6, ensembles, **caractérisé en ce que** la sortie du troisième miroir de courant est reliée à l'entrée du premier miroir de courant, et **en ce que** le premier miroir de courant comporte une sortie additionnelle fournissant le courant I'z.

**8.** Circuit interface selon les revendications 4 et 6 ensembles, **caractérisé en ce qu'**au premier miroir de courant est associé un autre miroir de courant (M'1), homologue, comprenant une entrée et deux sorties, pour l'alimentation des bases des troisième et quatrième transistors.

**9.** Circuit interface selon l'une quelconque des revendications 1 à 8, **caractérisé en ce qu'**il comporte en outre un générateur de signal d'alarme (150) muni de moyens exploitant le signe d'une différence entre un courant proportionnel au courant d'alimentation des bases Iz et I'z et un courant fixe déterminé.

**Claims**

**1.** An interface circuit for linking microprocessors, which circuit ensures that the current of the link does not exceed a limit value by inserting in said link (L1-L2) the emitter-collector path of a first transistor ($T_1$), **characterized in that** it comprises a second transistor ($T_2$) of the same polarity and having a geometry which is k times smaller than that of the first transistor, its emitter and base being connected to the emitter and the base, respectively, of the first transistor, and also comprises a base current generator (10), an input of which receives the collector current Iy of the second transistor and an output of which supplies a current Iz which feeds the bases of the first and the second transistor together, said current Iz being equal to a reference current wherefrom there is subtracted a current deduced from the current Iy in conformity with a rule such that beyond the limit value of the current in the link the first transistor leaves the saturated state which it normally has, thus imposing a voltage drop in the link.

**2.** An interface circuit as claimed in Claim 1, **characterized in that** the base current generator comprises a current source (So) which serves to generate the reference current (Io), a first current mirror (M1), an output of which forms the output of the generator supplying the current Iz, and a second current mirror (M2), an input of which constitutes the input of the generator, receiving the current Iy, and an output of which supplies a current which is subtracted from the refence current, this current difference being applied to the input of the first current mirror.

**3.** An interface circuit as claimed in Claim 2, **characterized in that** the first and the second current mirror are subject to multiplying factors m and n, respectively for their output current with respect to their input current.

**4.** An interface circuit as claimed in Claim 3, **characterized in that** the first current mirror comprises a supplementary output which supplies a current Ix which is subject to a multiplying factor p with respect to its input current, and **in that** said supplementary output is connected to the input of the second current mirror so that the second current mirror outputs a current only for as long as the collector current Iy of the second transistor remains smaller than the current Ix supplied by the supplementary output of the first current mirror.

**5.** An interface circuit as claimed in Claim 4, **characterized in that** the multiplying factors m, n and p are chosen so that the circuit is stabilized, by way of positive reaction, to a value $I_s$ of the link current which is smaller than a limit Imax of the link current when the latter is reached.

**6.** An interface circuit as claimed in Claim 1, **characterized in that** with the first transistor there is associated a third transistor ($T_3$) which has the same polarity and whose collector is connected to the emitter of the first transistor, its emitter being connected to the collector of the first transistor, **in that** a fourth transistor ($T_4$) which has the same polarity and a geometry which is k times smaller than that of the third transistor is associated with the third transistor, the bases and emitters of the third and the fourth transistor being interconnected, and **in that** the base current generator receives, on an additional input, a collector current Iy' of the fourth transistor and supplies, *via* an additional output, a current Iz' which feeds the bases of the third and the fourth transistor and whose variation rule with respect to Iy' and $I_o$ is identical to the variation rule of the current Iz with respect to the currents Iy and $I_o$, and is realized by way of similar means, comprising a third current mirror ($M_3$) whose input constitutes said additional input of the base current generator.

**7.** An interface circuit as claimed in the Claims 3 and 6 together, **characterized in that** the output of the third current mirror is connected to the input of the first current mirror, and **in that** the first current mirror comprises an additional output supplying the current I'z.

8. An interface circuit as claimed in the Claims 4 and 6 together, **characterized in that** with the first current mirror there is associated a further, similar current mirror (M' 1 which comprises one input and two outputs for feeding the bases of the third and the fourth transistor.

9. An interface circuit as claimed in any one of the Claims 1 to 8, **characterized in that** it also comprises an alarm signal generator (150) provided with means utilizing the sign of a difference between a current proportional to the supply current for the bases Iz and I'z and a given fixed current.


**Patentansprüche**

1. Schnittstellenanordnung zur Verbindung von Mikroprozessoren, dafür bestimmt, zu versichern, daß der Strom dieser Verbindung (L1-L2), durch Zwischenschaltung in diese Verbindung des Weges Emitter-Kollektor eines ersten Transistors (T1), einen Grenzwert nicht übersteigt, **dadurch gekennzeichnet, daß** sie einen zweiten Transistor (T2) selber Polarität und einer Geometrie k-mal kleiner als der des ersten Transistors enthält, dessen Emitter und Basis respektive mit dem Emitter und der Basis des ersten Transistors verbunden sind, und dadurch, daß sie einen Basisstromgenerator (10) enthält, der an einem Eingang den Kollektorstrom Iy des zweiten Transistors erhält und der an einen Ausgang einen Strom Iz liefert, der die gesamten Basen des ersten und zweiten Transistors versorgt, einen Strom Iz, der gleich einem Bezugsstrom ist, dem ein Strom entnommen wird, abgeleitet vom Strom Iy nach einem Gesetz, daß über dem Grenzwert des Stroms in der Verbindung der erste Transistor den Sättigungszustand, in dem er normalerweise ist, verläßt und so einen Spannungsabfall in die Verbindung zwischenschaltet.

2. Schnittstellenanordnung nach Anspruch 1, **dadurch gekennzeichnet, daß** der Basisstromgenerator eine Stromquelle ($S_0$) enthält, die zum Erzeugen des Bezugsstromes ($I_0$) dient, einen ersten Stromspiegel (M1), dessen Ausgang den Generatorausgang zum Liefern des Stromes Iz bildet, und einen zweiten Stromspiegel (M2), von dem ein Eingang den Generatoreingang bildet, der den Strom Iy erhält, und von dem ein Ausgang einen Strom liefert, der dem Bezugsstrom entnommen wird, wobei dieser Stromunterschied dem Eingang des ersten Stromspiegels zugeführt wird.

3. Schnittstellenanordnung nach Anspruch 2, **dadurch gekennzeichnet, daß** der erste und der zweite Stromspiegel respektive mit Multiplikativfaktoren m und n ihres Ausgangsstroms in bezug auf ihren Eingangsstrom versehen sind.

4. Schnittstellenanordnung nach Anspruch 3, **dadurch gekennzeichnet, daß** der erste Stromspiegel einen zusätzlichen Ausgang enthält, der einen Strom $I_0$ abgibt, dem ein Multiplikativfaktor p in bezug auf seinen Eingangsstrom zugeteilt ist, und daß dieser zusätzliche Ausgang mit dem Eingang des zweiten Stromspiegels verbunden ist, um diesen zweiten Stromspiegel zu unterbrechen, solange der Strom des Kollektors Iy des zweiten Transistors unter dem Wert des Stroms $I_0$ bleibt, vom zusätzlichen Ausgang des ersten Stromspiegels zugeführt.

5. Schnittstellenanordnung nach Anspruch 4, **dadurch gekennzeichnet, daß** die Multiplikativfaktoren m, n und p so gewählt werden, damit sich die Schaltung über positive Reaktion auf einen Wert $I_s$ des Verbindungsstroms stabilisiert, der unter einer Grenze Imax des Verbindungsstromes liegt, wenn diese erreicht wurde.

6. Schnittstellenanordnung nach Anspruch 1, **dadurch gekennzeichnet, daß** dem ersten Transistor ein dritter Transistor (T3) angeschlossen wird, selber Polarität, dessen Kollektor mit dem Emitter des ersten Transistors verbunden ist und dessen Emitter mit dem Kollektor des ersten Transistors verbunden ist, daß ebenso ein vierter Transistor (T4), selber Polarität und einer Geometrie k-mal kleiner als die des dritten Transistors, dem dritten Transistor angeschlossen wird, wobei die Basen und die Emitter des dritten und vierten Transistors respektive untereinander verbunden werden, und daß der Basisstromgenerator an einem zusätzlichen Eingang einen Kollektorstrom I'y eines vierten Transistors erhält und an einem zusätzlichen Ausgang einen Strom Iz' liefert, der die gesamten Basen des dritten und vierten Transistors versorgt, wobei das Variationsgesetz in bezug auf Iy' und $I_0$ identisch ist zu dem Variationsgesetz des Stromes Iz in bezug auf den Strom Iy un $I_0$, mit ähnlichen Mitteln erhalten, mit einem dritten Stromspiegel (M3), dessen Eingang den besagten zusätzlichen Eingang des Basisstromgenerators bildet.

7. Schnittstellenanordnung nach Anspruch 3 und 6, **dadurch gekennzeichnet, daß** der Ausgang des dritten Stromspiegels mit dem Eingang des ersten Stromspiegels verbunden ist und daß der erste Stromspiegel einen zusätzlichen, den Strom I'z liefernden Ausgang aufweist.

8. Schnittstellenanordnung nach Anspruch 4 und 6, **dadurch gekennzeichnet, daß** dem ersten Stromspiegel ein anderer, homologer Stromspiegel (M'1) angeschlossen ist, mit einem Eingang und zwei Ausgängen für die Versorgung der Basen des dritten und vierten Transistors.

9. Schnittstellenanordnung nach einem beliebigen Anspruch 1 bis 8, **dadurch gekennzeichnet, daß** sie zudem einen Warnsignalgenerator (150) enthält, mit Mitteln versehen, um das Vorzeichen einer Differenz zwischen einem zum Versorgungsstrom der Basen Iz und I'z proportionalen Strom und einem bestimmten festen Strom zu nutzen.

FIG.1

FIG.2

FIG.3

FIG.4

FIG.5

FIG.6